# EUROPÄISCHE PATENTSCHRIFT

(11) **EP 4 646 762 B1**
(45) Veröffentlichungstag und Bekanntmachung des Hinweises auf die Patenterteilung: **08.04.2026**
(21) Anmeldenummer: 24720801.0
(22) Anmeldetag: 18.04.2024
(51) Int. Cl.: H01P 1/205, G01R 33/36

(54) **HOCHFREQUENZ-BANDPASSFILTER FÜR EINE MR-APPARATUR MIT SPULENKÖRPER MIT EINEM HOHLRAUM, MR-APPARATUR**
HIGH-FREQUENCY BANDPASS FILTER FOR AN MR APPARATUS WITH COIL BODY HAVING A CAVITY, MR APPARATUS
FILTRE PASSE-BANDE HAUTE FRÉQUENCE POUR APPAREIL RM COMPORTANT UN CORPS DE BOBINE AYANT UNE CAVITÉ ET APPAREIL RM

(30) Priorität: 28.04.2023 DE 102023203996
(43) Veröffentlichungstag der Anmeldung: 12.11.2025
(73) Patentinhaber: Bruker Switzerland AG, 8117 Fällanden (CH)
(72) Erfinder: SCHMITTER, Fabian, 8603 Schwerzenbach (CH); LUKE, Martin, 8117 Fällanden (CH); SCHWILCH, Arthur, 8625 Gossau (CH)
(74) Vertreter: Kohler Schmid Möbus Patentanwälte
(86) Internationale Anmeldenummer: PCT/EP2024/060527
(87) Internationale Veröffentlichungsnummer: WO 2024/223395

(56) Entgegenhaltungen:
- JP-A- 2001 127 502
- KR-A- 20040 100 084
- KR-A- 20050 009 603
- KR-B1- 100 368 035
- US-A1- 2019 058 235
- MEHDIZADEH M ET AL: "Loop-Gap Resonator: A Lumped Mode Microwave Resonant Structure", IEEE TRANSACTIONS ON MICROWAVE THEORY AND TECHNIQUES, IEEE, USA, vol. 30, no. 12, 1 December 1983 (1983-12-01), pages 1059 - 1064, XP011244392, ISSN: 0018-9480
- HARDY W ET AL: "Split-ring resonator for use in magnetic resonance from 200-2000 MHz", REVIEW OF SCIENTIFIC INSTRUMENTS, 1 February 1981 (1981-02-01), 2 Huntington Quadrangle, Melville, NY 11747, pages 213 - 216, XP093171752, ISSN: 0034-6748, Retrieved from the Internet <URL:https://watermark.silverchair.com/213_1_online.pdf?token=AQECAHi208BE49Ooan9kkhW_Ercy7Dm3ZL_9Cf3qfKAc485ysgAABWcwggVjBgkqhkiG9w0BBwagggVUMIIFUAIBADCCBUkGCSqGSIb3DQEHATAeBglghkgBZQMEAS4wEQQMEAZHcP_PJd6aVr9JAgEQgIIFGgEvJwSpgWCaRGBq6_xvKvvjuWVQtkBaV3uKkH17QZa9XCNauZ9A3vZDnXjptpAXutOBuPVtGaCKq0Oo6g1EuPJ> DOI: 10.1063/1.1136574
- MOMO F ET AL: "On the design of a split ring resonator for ESR spectroscopy between 1 and 4 GHz", JOURNAL OF PHYSICS E.SCIENTIFIC INSTRUMENTS,, vol. 16, no. 1, 1 January 1983 (1983-01-01), pages 43 - 46, XP001366782

## Beschreibung

### Hintergrund der Erfindung

Die Erfindung betrifft eine MR-Apparatur mit einer Sende- und/ oder Empfangsanordnung mit einem Hochfrequenz-Bandpassfilter.

Für Sende- und Empfangsvorrichtungen von MR-Apparaturen, z.B. NMR-Spektrometern, werden Bandpassfilter mit einem Frequenzband im zwei- bis dreistelligen MHz-Bereich benötigt. Herkömmliche Bandpassfilter für diese Aufgabenstellung werden typischerweise mittels gewickelter Zylinderspulen und/oder gefräster Wendelresonatoren im Guss- oder Fräsgehäuse auf Einzelleiterplatten hergestellt.
[1] offenbart ein solches Bandpassfilter-Design. Der aufgrund von Toleranzen notwendige Frequenzabgleich erfolgt über Trimmkondensatoren. Die aktiven und passiven Einheiten werden typischerweise mit Koaxialkabel und Koaxialsteckverbindern miteinander verschaltet. Derartige Bandpassfilter erfordern jedoch einen hohen manuellen Aufwand beim Aufbau der Filter und beim nachfolgenden Abgleich. Darüber hinaus muss eine Vielfalt an Spulen bzw. Wendelresonatoren und Trimmkondensatoren vorrätig gehalten werden, was die Herstellkosten in die Höhe treibt. Der ganze Aufbau ist zudem anfällig auf mechanische Erschütterungen und Vibrationen, und weist eine gewisse Temperaturabhängigkeit auf.
[7] offenbart einen Bandpassfilter vom Typ eines dielektrischen Resonators mit einer symmetrischen Dämpfungspunktcharakteristik. Der Bandpassfilter ist mit einem Eingangsmittel versehen, das ein Mikrowellen-Eingangssignal in einen Hohlraum 41 einspeist, mit dielektrischen Resonatoren 20, 21, die Bandpassfilter für ein Eingangssignal bilden.
[8] offenbart einen Loop-Gap-Resonatoren. Der Resonator umfasst Mikrowellenresonanzstrukturen mit einer Feldkonfiguration, die zwischen "lumped" und "distributed" liegt und eine Alternative zu dielektrischen und akustischen Oberflächenwellenresonatoren bei niedrigen Mikrowellenfrequenzen darstellen soll
[9] offenbart einen Split-Ring-Resonator für die Magnetresonanz von 200-2000 MHz.

### Aufgabe der Erfindung

Es ist Aufgabe der Erfindung, einen kompakten HF-Bandpassfilter vorzuschlagen, der eine hohe Güte, eine hohe elektrische Belastbarkeit und gleichzeitig ein niedriges Impedanz-Niveau aufweist und einfach und kostengünstig herstellbar ist.

### Beschreibung der Erfindung

Diese Aufgabe wird erfindungsgemäß gelöst durch eine MR-Apparatur mit einer Sende- und/oder Empfangsanordnung mit einem Hochfrequenz-Bandpassfilter gemäß Anspruch

Erfindungsgemäß umfasst die Induktivität einen elektrisch leitenden Spulenkörper mit einem Hohlraum, der im Wesentlichen HF-dicht verschlossen ist. Im Wesentlichen "HF-dicht" bedeutet, dass das magnetische Feld sich im Spulenkörper ausbreitet und das Streufeld außerhalb des Spulenkörpers minimal ist. Die HF-Dichtheit wird durch die Form und die Materialwahl des Spulenkörpers realisiert. Der magnetische Fluss wird in dem erfindungsgemäßen Resonator also im Wesentlichen vollständig (> 99%, vorzugsweise > 99,9%) innerhalb des Spulenkörpers gehalten, so dass das Streufeld außerhalb des Spulenkörpers minimiert wird.

Resonatoren mit einer Induktivität mit Hohlraum, werden bereits für verschiedene Anwendungen als verstimmbarer Schwingkreis verwendet [2], [3], [4], [5], [6]. Hierbei ist eine HF-Dichtheit nicht erforderlich und daher auch nicht gegeben.

Bei der vorliegenden Erfindung wird der Resonator nicht als verstimmbarer Schwingkreis, sondern als HF-Filter eingesetzt, vorzugsweise mit einer unveränderlichen Resonanzfrequenz. Durch die einen Hohlraum umschließende Form des Resonators weist dieser eine hohe Güte und damit auf der Resonanzfrequenz einen hohen elektrischen Widerstand auf. Durch die erfindungsgemäße Form und das damit verbundene große Volumen des Spulenkörpers ergibt sich (außerhalb der Resonanzfrequenz) sowohl ein geringer elektrischer als auch ein geringer thermischer Widerstand. Dadurch wird eine hohe Belastbarkeit erreicht, insbesondere in Kombination mit einer hohen Spanungsfestigkeit der Kapazität.

Die erfindungsgemäße Geometrie sorgt für eine kleine Induktivität des Spulenkörpers und somit zusammen mit einer großen Kapazität für ein niedriges Impedanz-Niveau.

Ein Teil des erfindungsgemäßen Bandpassfilters kann auf einfache Weise in Form einer maschinell bestückbaren Flachbaugruppe hergestellt werden. Die Flachbaugruppe kann zusätzliche aktive Elektronik für die MR-Apparatur (z.B. Schalter, Verstärker usw.) enthalten, was den Aufbau vereinfacht und kostengünstig herzustellen ist.

Die Kapazität des Resonators kann einen oder mehrere Kondensatoren umfassen und bildet mit dem Spulenkörper einen elektrischen Schwingkreis. Der Spulenkörper ist vorzugsweise metallisch, insbesondere aus Aluminium und weist in einer bevorzugten Ausführungsform eine elektrisch leitende Außenwandung und ein zentrales elektrisch leitendes Stützelement auf, die einen bspw. toroidähnlichen Hohlraum ausbilden. Der Spulenkörper kann beispielsweise in Form eines Fräs- oder Gussgehäuses oder einer Kombination daraus vorliegen.

Vorzugsweise ist der Hohlraum des Spulenkörpers rotationssymmetrisch mit einer toroidalen Oberfläche, also einer Rotationsfläche, die in der Mitte ein Loch hat (Rotationsachse verläuft durch Loch und schneidet die Rotationsfläche nicht). Der Querschnitt des Rotationskörpers parallel zur Rotationsachse kann beliebig geformt sein und ist vorzugsweise rechteckig mit zumindest an einer Seite abgerundeten Kanten. Es ergibt sich dabei ein abschnittsweise hohlzylinderförmiger Hohlraum. Dabei bildet die Achse des Hohlzylinders die Resonatorachse. Unter "abschnittsweise hohlzylinderförmig" fällt also unter anderem auch ein Zylinder mit zumindest teilweise abgerundeten Kanten. In diesem Fall verjüngt sich der Hohlraum-Querschnitt parallel zur Resonatorachse bzw. die Hohlraumquerschnitte senkrecht zur Resonatorachse sind für verschiedenen Positionen entlang der Resonatorachse unterschiedlich groß.

Erfindungsgemäß weist der Resonator ein Deckelelement auf, das zusammen mit dem Spulenkörper den Hohlraum begrenzt. Das Deckelelement ist ein im Wesentlichen HF-dichtes, wahlweise flächiges Element, das gegebenenfalls auf die offene Stelle des Spulenkörpers aufgesetzt wird. Das Deckelelement kann zum Beispiel durch Schrauben, Pressen, Klemmen oder Löten an dem Spulenkörper befestigt sein.

Vorzugsweise ist das Deckelelement als Leiterplatte ausgebildet. Alternativ kann als Deckelelement ein weiteres Metallteil (bzw. metallisiertes Teil) verwendet werden.

Das Deckelelement ist vorzugsweise elektrisch isolierend und ist auf der dem Hohlraum zugewandten Seite größtenteils mit einem elektrisch. leitendem Material versehen, insbesondere beschichtet.

Vorzugsweise ist die dem Hohlraum zugewandte Seite (Unterseite) vollständig mit einem elektrisch leitenden Material beschichtet mit Ausnahme von Bereichen, in denen ev. Kondensatoren vorgesehen sind. Wenn die Kondensatoren an dem Deckelelement angeordnet sind, kann das Deckelelement nicht durchgehend beschichtet sein, da dies die Kondensatoren kurzschließen würde.

Eine durchgehend beschichtete Unterseite des Deckelelements kann bspw. dann vorgesehen werden, wenn die Kapazität im Stützelement angeordnet ist (s.u.).

Bei einer besonders bevorzugten Ausführungsform weist das Deckelelement mindestens einen Durchgangskontakt auf, der eine der Kontaktflächen der Kapazität und den Spulenkörper mit dem Signaleingang bzw. Signalausgang verbindet.

Der Durchgangskontakt kontaktiert das Stützelement entweder direkt oder über eine leitende Beschichtung der dem Hohlraum zugewandten Seite des Deckelelements. Umfasst die Kapazität mehrere Kondensatoren, verbindet der Durchgangskontakt jeweils eine Kontaktfläche aller Kondensatoren mit dem Spulenelement.

Bei einer besonders bevorzugten Ausführungsform handelt es sich bei dem Deckelelement um eine Leiterplatte.

Vorzugsweise sind zur Signaleinkopplung in den Signaleingang eine elektrische Eingangsleitung und zur Signalauskopplung aus dem Signalausgang eine elektrische Ausgangsleitung vorhanden, die vorzugsweise auf der Außenseite des Deckelelements angeordnet sind.

Der Signaleingang und der Signalausgang können an einer gemeinsamen Kontaktstelle angeordnet sein. Das Signal wird dann am selben Port (Kontaktstelle des Resonators zur Eingangs- bzw. Ausgangsleitung) ausgekoppelt wie es eingekoppelt wird (1-Port). Wird der Resonator als 1-Port kontaktiert, kann er als Serie- oder Parallelschwingkreis verwendet werden.

Alternativ können Signaleingang und Signalausgang an verschiedenen Kontaktstellen angeordnet sein. Das Signal wird dann also an einem anderen Port ausgekoppelt als es eingekoppelt wird. Wird der Resonator als 2-Port kontaktiert, ist er besser als Bandpassfilter geeignet.

Erfindungsgemäß ist die Kapazität innerhalb des Hohlraums angeordnet. Dadurch werden elektromagnetische Verluste vermindert.

Die dem Hohlraum zugewandte Seite des Deckelelements ist bei dieser Ausführungsform vorzugsweise so elektrisch leitend beschichtet, dass die Beschichtung zwei voneinander galvanisch getrennte Teilbeschichtungen umfasst, wobei eine Teilbeschichtung mit einer ersten Kontaktfläche der Kapazität und die andere Teilbeschichtung mit einer zweiten Kontaktfläche der Kapazität galvanisch verbunden ist.

Zusätzlich kann die Kapazität auch außerhalb des Hohlraums angeordnet sein. Dies hat Vorteile für den Abgleich des Resonators in eingebautem Zustand. Das Deckelelement ist dann vorzugsweise sowohl auf der dem Hohlraum zugewandten Seite (Unterseite) als auch auf der dem Hohlraum abgewandten Seite (Oberseite) mit einem elektrisch leitenden Material beschichtet. Der Grad der Beschichtung hängt von der Menge und der Anordnung der Kondensatoren außerhalb des Hohlraums ab.

Erfindungsgemäß ist zwischen der vom Hohlraum abgewandten Seite und der dem Hohlraum zugewandten Seite des Deckelelements eine elektrisch leitende Zwischenschicht angeordnet. Die Zwischenschicht verbindet die radial äußeren Kontaktflächen verschiedener Kondensatoren der Anordnung galvanisch mit einer tiefen Impedanz. Die Zwischenschicht dient dazu, den Hohlraum elektromagnetisch abzuschließen, insbesondere wenn die Kapazität Kondensatoren innerhalb des Hohlraums aufweist, da in diesem Fall die dem Hohlraum zugewandte Seite nicht vollständig elektrisch leitend beschichtet werden kann. Dadurch wird das Streufeld außerhalb des Hohlraums minimiert und somit die HF-Dichtheit optimiert.

Die galvanische Verbindung erfolgt vorzugsweise über Sacklochkontakte zu der dem Hohlraum zugewandten Seite des Deckelelements und über die Durchgangskontakte des Deckelelements. Statt Sacklochkontakte können auch Durchgangskontakte verwendet werden.

Die Kapazität kann mehrere parallel geschaltete Kondensatoren umfassen. Dabei sind die Kondensatoren vorzugsweise symmetrisch, insbesondere rotationssymmetrisch, um die Resonatorachse, angeordnet. Die Anordnung der Kondensatoren ist vorzugsweise so gewählt, dass mit ihnen eine möglichst kleine Fläche aufgespannt wird. Dadurch werden andere (störende) Resonanzen effektiv unterdrückt. Besonders bevorzugt ist eine kreisförmige Ringstruktur, in der die Kondensatoren möglichst nah beieinander angeordnet sind. Die Kapazität zwischen dem Stützelement und einer ggf. vorhandenen elektrisch leitenden Zwischenschicht wird dadurch verringert.

Bei einer speziellen Ausführungsform wird die Kapazität von einer mit elektrisch leitendem Material beschichteten Isolatorscheibe, insbesondere einer Keramikscheibe, gebildet. Die Beschichtung bildet dabei die Kontaktflächen der Kapazität. Vorzugsweise ist bei dieser Ausführungsform die Isolatorscheibe zwischen dem Stützelement und dem Deckelelement angeordnet. Die Isolatorscheibe ist dann an ihren zwei gegenüberliegenden Seiten elektrisch leitend beschichtet und verbindet das Deckelement mit dem Spulenkörper mechanisch. Hierdurch wird eine besonders kompakte Ausführung der Kapazität realisiert. Die erste Kontaktfläche ist vorzugsweise mit der Unterseite des Deckelelements elektrisch verbunden.

Die Isolatorscheibe ist vorzugsweise als Ring mit einer zentralen Durchkontaktierung ausgebildet.

Um die Filterwirkung zu verbessern, sieht eine besonders bevorzugte Ausführungsform des erfindungsgemäßen Hochfrequenz-Bandpassfilters vor, dass die Resonatoranordnung mindestens zwei Resonatoren umfasst, die miteinander gekoppelt sind. Bei gekoppelten Resonatoren sind Eingangsleitung und Ausgansleitung vorzugsweise an Ports verschiedener Resonatoren angeschlossen.

Vorzugsweise sind die Resonatoren über ihre magnetischen Felder gekoppelt, wobei die Hohlräume von jeweils zwei der mindestens zwei Resonatoren über Öffnungen in den Spulenkörpern miteinander verbunden sind.

Alternativ ist auch eine Kopplung über passive Elemente (Spulen, Kondensatoren, Leitungen) möglich.

Die Mittenfrequenz des erfindungsgemäßen HF-Bandpassfilters liegt vorzugsweise im zwei- bis dreistelligen MHz-Bereich. Dies kann bspw. durch folgende Kenndaten für den Resonator realisiert werden: Durchmesser des Hohlraums: 32 mm - 90 mm, Höhe des Hohlraums: 7 mm - 22 mm, dadurch gegebene Induktivität des Spulenkörpers: 1.5 nH - 7.0 nH.

Die Leistungsfestigkeit der Resonatoren wird durch die Leistungsfestigkeit der Kondensatoren und der Isolation des Deckelelements limitiert. Der erfindungsgemäße HF-Bandpassfilter ist für Leistungen größer als 500 W geeignet und kann daher vorteilhaft für HR (High Resolution) und MAS (Magic Angle Spinning) MR-Anwendungen eingesetzt werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern diese Kombinationen im Schutzbereich der beigefügten Ansprüche bleiben." Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

- Fig. 1: zeigt einen Querschnitt eines Resonators eines erfindungsgemäßen HF-Bandpassfilters mit innerhalb des Hohlraums angeordneten Kondensatoren.
- Fig. 2: zeigt die Projektion der Komponenten des Resonators aus Fig. 1.
- Fig. 3: zeigt einen Querschnitt einer Resonatoranordnung mit dem Resonator aus Fig. 1 und einem 1-Port-Anschluss und schematisch dargestelltem Signalfluss.
- Fig. 4: zeigt die Projektion der Komponenten der Resonatoranordnung aus Fig. 3.
- Fig. 5: zeigt ein Ersatzschaltbild der Resonatoranordnung aus Fig. 3.
- Fig. 6: zeigt einen Querschnitt einer Resonatoranordnung mit dem Resonator aus Fig. 1 und einem 2-Port-Anschluss und schematisch dargestelltem Signalfluss.
- Fig. 7: zeigt die Projektion der Komponenten der Resonatoranordnung aus Fig. 6.
- Fig. 8: zeigt ein Ersatzschaltbild der Resonatoranordnung aus Fig. 6.
- Fig. 9: zeigt einen Querschnitt eines Resonators eines erfindungsgemäßen HF-Bandpassfilters mit innerhalb und außerhalb des Hohlraums angeordneten Kondensatoren.
- Fig. 10: zeigt einen Querschnitt eines Resonators eines erfindungsgemäßen HF-Bandpassfilters mit einem Kondensator, der in Form einer zentralen Isolatorscheibe ausgebildet ist.
- Fig. 11: zeigt den schematisch dargestelltem Signalfluss im Resonator aus Fig. 10.
- Fig. 12: zeigt eine perspektivische Schnittdarstellung eines Spulenelements einer besonders bevorzugten Ausführungsform des erfindungsgemäßen HF-Bandpassfilters mit gekoppelten Resonatoren.
- Fig. 13: zeigt die Projektion der Komponenten der Resonatoranordnung mit gekoppelten Resonatoren.
- Fig. 14: zeigt ein Ersatzschaltbild der Resonatoranordnung mit gekoppelten Resonatoren.

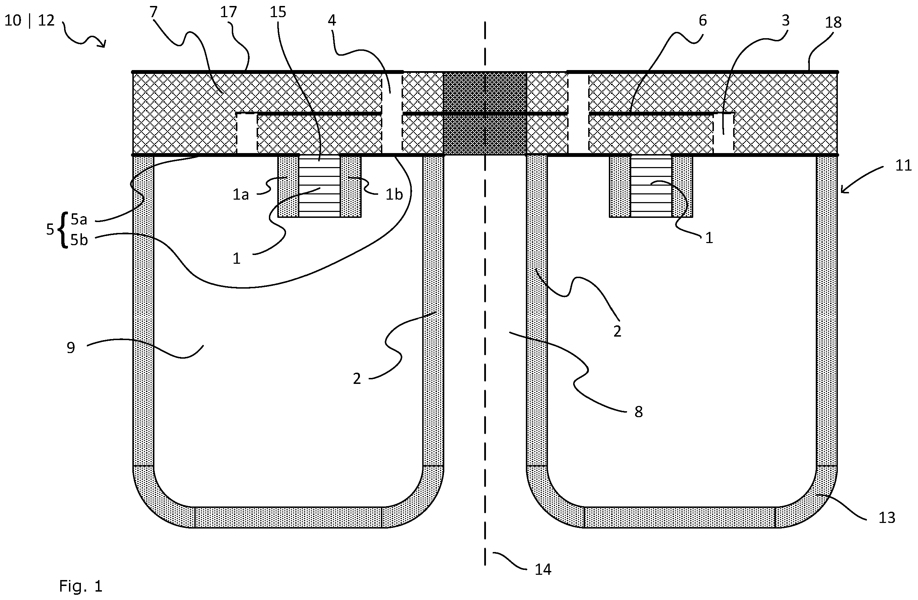

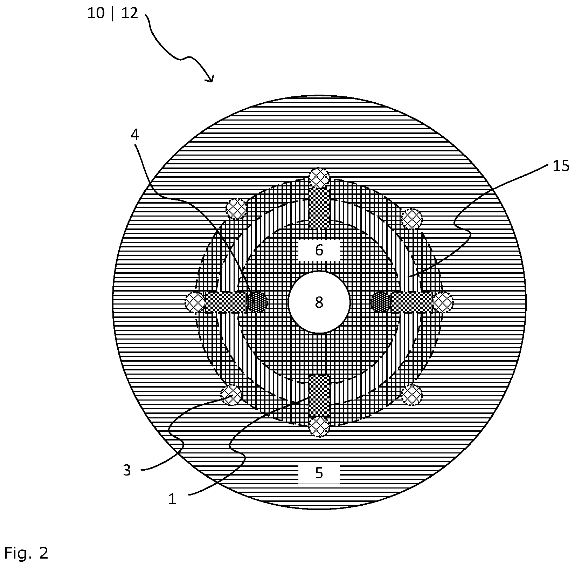

**Fig. 1** und **Fig. 2** zeigen einen Querschnitt bzw. eine Projektion einer ersten Ausführungsform eines Resonators **10** eines erfindungsgemäßen HF-Bandpassfilters **12.** Der Resonator 10 umfasst eine Induktivität, die in Form eines Spulenkörpers **11** mit einem Hohlraum **9** ausgebildet ist und mit den Kondensatoren 1 einen Schwingkreis bildet. Der Resonator 10 weist eine Kapazität auf, die von innerhalb des Hohlraums 9 angeordneten Kondensatoren **1** gebildet wird.

Der Spulenkörper 11 der gezeigten Ausführungsformen ist rotationssymmetrisch, wobei der Hohlraum 9 des Spulenkörpers 11 im Wesentlichen hohlzylinderförmig ist mit teilweise abgerundeten Kanten im unteren Bereich des Spulenkörpers 11, also auf der dem Deckelelement 7 entgegengesetzten Seite des Spulenkörpers 11. Der Spulenkörper 11 weist eine große elektrisch leitende Oberfläche und somit einen geringen elektrischen. Widerstand auf.

Der Spulenkörper 11 umfasst ein zentrales elektrisch leitendes Stützelement **2** (radial innerer, also achsnaher, Teil der in Fig. 1 im Querschnitt U-förmigen Wandung), eine Außenwandung **13** (unterer und radial äußerer, also achsferner, Teil der in Fig. 1 gezeigten im Querschnitt U-förmigen Wandung). Der Resonator 12 umfasst ein Deckelelement **7,** das den Spulenkörper 11 zu einem Gehäuse verschließt.

Das Stützelement 2 und die Außenwandung 13 sind aus einem elektrisch leitenden Material gefertigt. Das Stützelement 2 ist vorzugsweise hohl ausgebildet und weist eine zentrale Durchgangsöffnung **8** auf. Bei dem Deckelelement 7 handelt es sich vorzugsweise um einen leitend beschichteten Isolator, insbesondere eine Leiterplatte, deren Unterseite (dem Hohlraum 9 zugewandte Seite) mit einer elektrisch leitenden Schicht **5** (waagrechte Strichelung in Fig. 2) versehen, insbesondere beschichtet, ist. Zwischen den beiden Kontaktflächen 1a, 1b des Kondensators 1 besitzt die Unterseite des Deckelelements 7 keine elektrisch leitende Beschichtung. Die elektrisch leitende Schicht 5 umfasst bei der in Fig. 1 und Fig. 2 gezeigten Ausführungsform daher Teilbeschichtungen **5a, 5b,** die galvanisch voneinander getrennt sind, wobei die erste Teilbeschichtung 5a galvanisch mit jeweils einer ersten Kontaktfläche **1a** der Kondensatoren 1 verbunden ist und elektrisch auf einem Referenzpotential liegt (z.B. Erdpotential). Die zweite Teilbeschichtung 5b ist galvanisch mit jeweils einer zweiten Kontaktfläche **1b** der Kondensatoren 1 verbunden. Generell wird die Anordnung der Kondensatoren 1 so gewählt, dass mit ihnen eine möglichst kleine Fläche aufgespannt wird, um störende Resonanzen gut unterdrücken zu können.

Um den Hohlraum 9 trotz der unbeschichteten Fläche 15 elektromagnetisch bestmöglich abzuschließen, kann zwischen der Oberseite und der Unterseite des Deckelelements 7 (also innerhalb des Deckelelements 7) eine elektrisch leitende Zwischenschicht **6** (senkrechte Strichelung in Fig. 2) vorgesehen sein, die die radial äußeren Kontaktflächen 1a der Kondensatoren 1 galvanisch mit einer tiefen Impedanz miteinander verbindet. Bei der in Fig. 1 und Fig. 2 gezeigten Ausführungsform erfolgt diese galvanische Verbindung über die erste Teilbeschichtung 5a und zum Hohlraum 9 hin offene Sacklochkontakte **3.** Bis auf die Öffnungen im Durchgangskontakt 4 ist der Hohlraum 9 elektromagnetisch abgeschlossen.

Die Kondensatoren 1 sind bei der vorliegenden Ausführungsform in einer kreisförmigen Ringstruktur (also im gleichen Abstand zu einer Resonatorachse **14)** gleichmäßig um die Resonatorachse 14 verteilt angeordnet, wie in Fig. 2 gezeigt. Dadurch können die Kondensatoren 1 möglichst nahe beieinander angeordnet werden, wodurch die Kapazität zwischen dem Stützelement 2 und der elektrisch leitenden Zwischenschicht 6 verringert wird. Die Teilbeschichtungen 5a, 5b der elektrisch leitenden Schicht sind entsprechend ringförmig und konzentrisch und sind von einer umgeschichteten ringförmigen Fläche **15** getrennt. Alternativ könnte auch ein einziger Ringkondensator (mit 2 ringförmigen Kontaktflächen) vorgesehen sein.

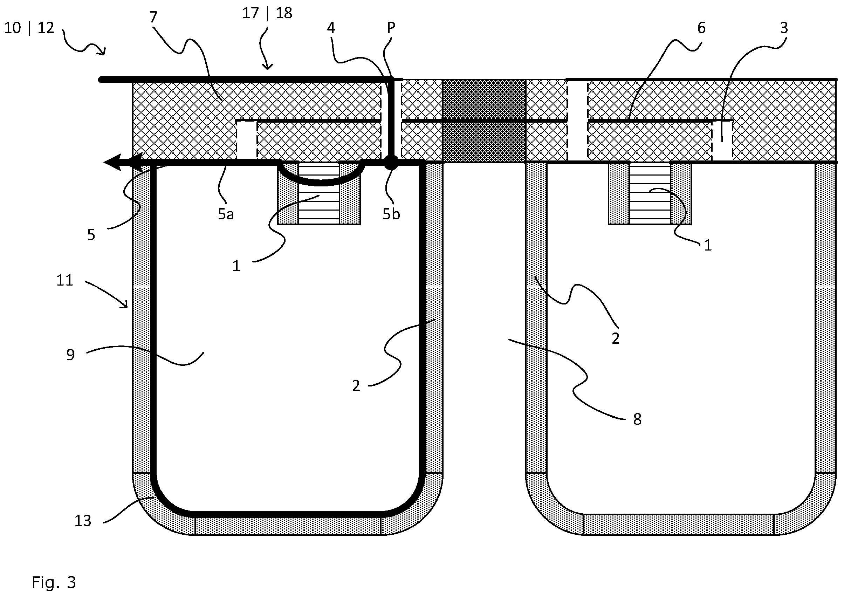

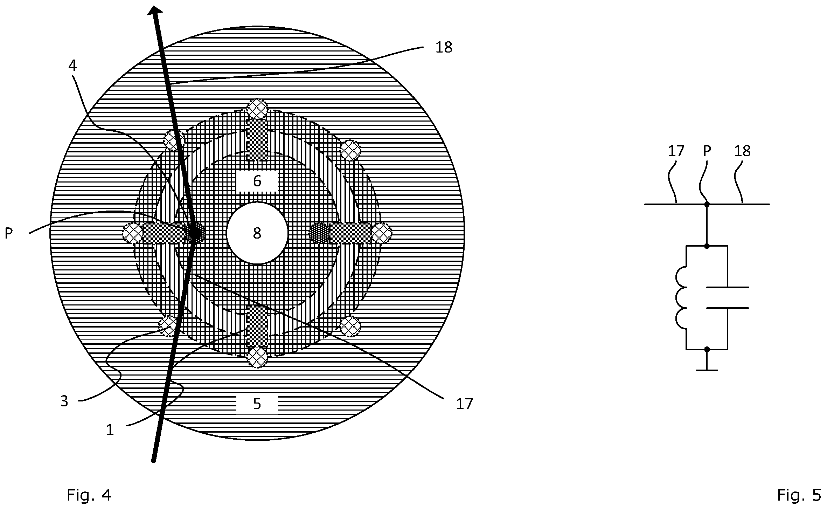

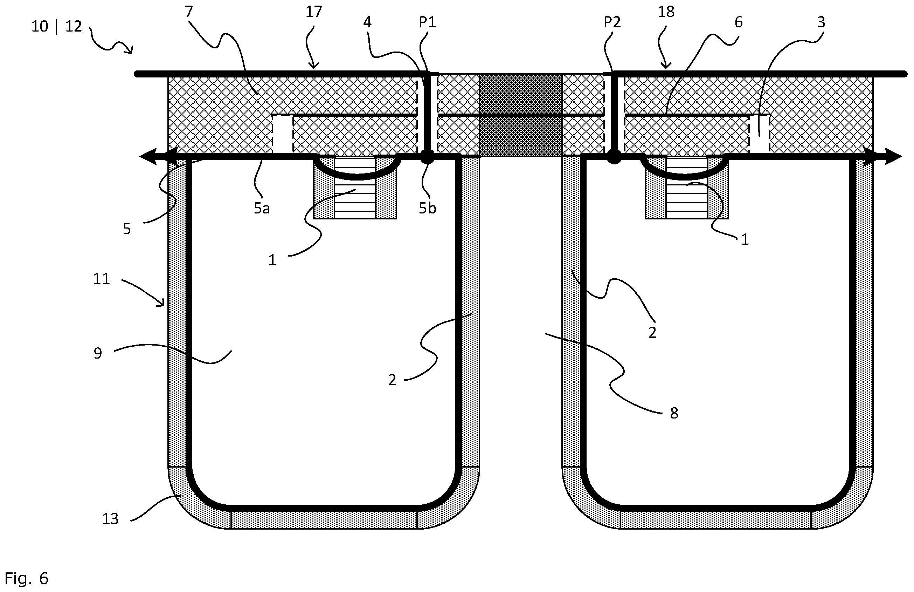

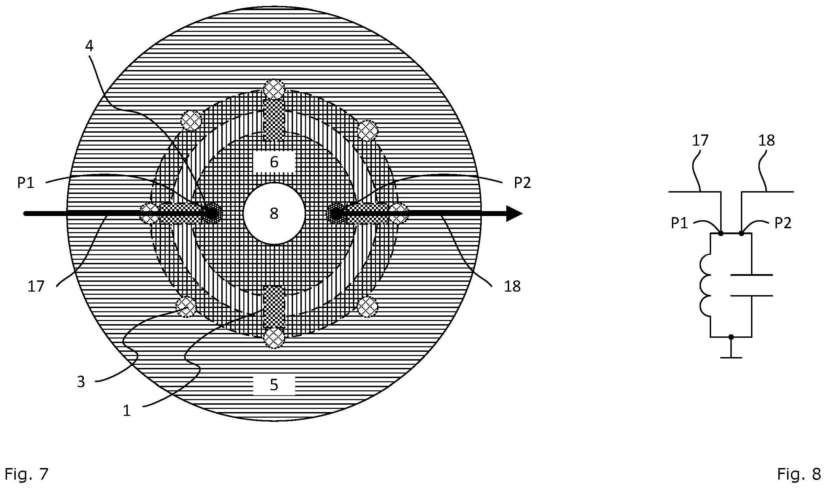

Der erfindungsgemäße HF-Bandpassfilter 12 kann über Ports **P, P1, P2** an eine Komponente einer MR-Apparatur angeschlossen werden. Dazu umfassen die Ports einen Signaleingang zum Einkoppeln eines zu filternden Signals und/oder einen Signalausgang zum Auskoppeln eins gefilterten Signals. Der Resonator 1 kann als 1-Port (Signaleingang und Signalausgang in einem einzigen Port P realisiert) beschaltet sein, wie in **Fig. 3** und **Fig. 4** gezeigt. Ein entsprechendes Ersatzschaltbild ist in **Fig.** 5 dargestellt. **Fig. 6** und **Fig. 7** zeigen eine alternative Beschaltung über zwei getrennte Ports P1, P2 (2-Port). Ein entsprechendes Ersatzschaltbild ist in **Fig. 8** dargestellt. Beide Anschlussmöglichkeiten (1-Port und 2-Port) sind mit allen hier beschriebenen Ausführungsformen 12, 12', 12" realisierbar und sind am Beispiel der ersten Ausführungsform 12 in Fig. 3 bis 7 dargestellt. Bei der ersten Ausführungsform des HF-Bandfilters 12 sind die Ports P, P1, P2 über Durchgangskontakte **4** mit der zweiten Teilbeschichtung 5b galvanisch verbunden. Die Durchgangskontakte 4 stehen somit in galvanischem Kontakt mit der Oberseite und der Unterseite des Deckelelements 7, sind aber mit der Zwischenschicht 6 nicht galvanisch verbunden. Eine Eingangsleitung **17** und eine Ausgangsleitung **18** führen von dem Port P bzw. den Ports P1, P2 des HF-Bandpassfilters 12 zu der anzuschließenden Komponente (nicht gezeigt). Die Eingangsleitung 17 und die Ausgangsleitung 18 sind vorzugsweise als Leiterbahnen auf der dem Hohlraum abgewandten Seite des Deckelelements 7 ausgebildet.

In Fig. 3 und Fig. 6 ist der Signalfluss für die 1-Port bzw. 2-Port-Variante des HF-Bandpassfilters 12 gezeigt. Das zu filternde HF-Signal wird über die leitenden Teile der Oberfläche des Deckelelements (Eingangsleitung 17) angekoppelt und tritt durch den Durchgangskontakt 4 durch das Deckelelement hindurch. Am unteren Ende des Durchgangskontakts 4 teilt sich das HF-Signal auf. Hochfrequente Anteile eines über die Eingangsleitung 17 eingekoppelten zu filternden HF-Signals werden vom Signaleingangs-Port P bzw. P1 über die zweite Teilbeschichtung 5b des Deckelelements 7, die Kondensatoren 1 und die erste Teilbeschichtung 5a des Deckelelements 7 auf ein Referenzpotential (z.B. Erdpotential) geleitet. Niederfrequente Anteile des zu filternden HF-Signals werden vom Signaleingangs-Port P bzw. P1 über die zweite Teilbeschichtung 5b des Deckelelements 7, das Stützelement 2 entlang der Innenwand des Hohlraums 9, der Außenwandung 13 des Spulenkörpers 11 zur Unterseite des Deckelelements 7 auf ein Referenzpotential (z.B. Erdpotential) geleitet. Für Frequenzen nahe der Resonanzfrequenz des Resonators ist der Resonator hochohmig. Die entsprechenden Anteile des zu filternden HF-Signals schwingen im Resonator und können über den Signalausgangs-Port P bzw. P2 aus dem HF-Bandpassfilter 12 ausgekoppelt werden. Da die Frequenz der zu filternden HF-Signale im MHz-Bereich liegt, findet der Signaltransport nur über die elektrisch leitenden Oberflächen des Resonators 2 statt.

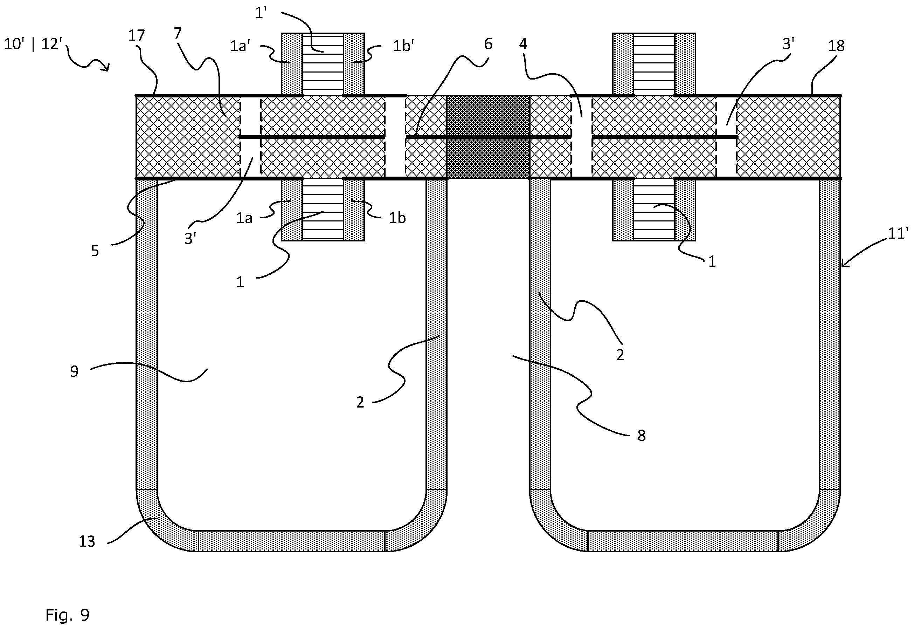

**Fig. 9** zeigt einen Querschnitt einer zweiten Ausführungsform eines Resonators **10'** eines erfindungsgemäßen HF-Bandpassfilters **12'** mit einem Spulenkörper **11'** einer Kapazität, die von innerhalb des Hohlraums 9 angeordneten Kondensatoren 1 und von außerhalb des Hohlraums 9 angeordneten Kondensatoren **1'** gebildet wird.

Dabei sind die ersten Kontaktflächen 1a, **1a'** der innerhalb und außerhalb des Hohlraums 9 angeordneten Kondensatoren 1, 1' über weitere Durchgangskontakte **3'** galvanisch miteinander verbunden. Ebenso sind die zweiten Kontaktflächen 1b, 1b' der innerhalb und außerhalb des Hohlraums 9 angeordneten Kondensatoren 1, 1' galvanisch miteinander verbunden. Im Gegensatz zu den Durchgangskontakten 4 sind die weiteren Durchgangskontakte 3' nicht nur mit der Oberseite und der Unterseite des Deckelelements 7 galvanisch verbunden, sondern auch mit der Zwischenschicht 6. Die weiteren Durchgangskontakte 3' erfüllen daher auch die Funktion der Sacklochkontakte 3 aus Fig. 1. Die Eingangsleitung 17 ist mit den zweiten Kontaktflächen 1b der Kondensatoren 1, 1' galvanisch verbunden und muss ggf. entsprechend um die ersten Kontaktflächen 1b' der außerhalb des Hohlraums 9 angeordneten Kondensatoren 1' herumgeführt werden. Die Eingangsleitung 17 kann alternativ auch über eine weitere Zwischenschicht (nicht gezeigt) zur Kontaktfläche 1b' geführt werden.

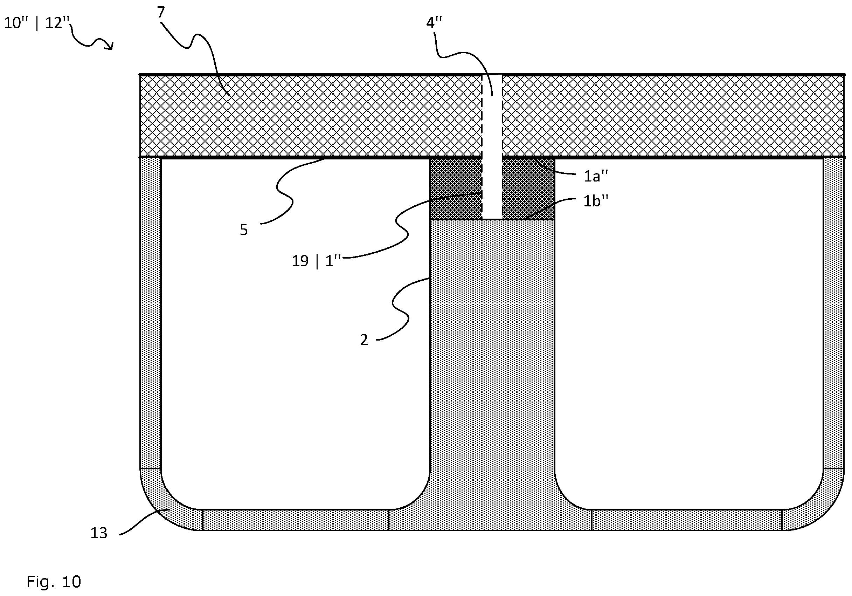

**Fig. 10** zeigt einen Querschnitt einer dritten Ausführungsform eines Resonators **10"** eines erfindungsgemäßen HF-Bandpassfilters **12"** mit einem Kondensator 1", der in Form einer zentralen Isolatorscheibe (z.B. eine isolierende Folie oder eine Keramikscheibe) ausgebildet ist, die beidseits elektrisch leitend beschichtet ist (Kondensator 1"). Die Beschichtungen der Isolatorscheibe bilden Kontaktflächen 1a", 1b" des Kondensators 1". Bei dieser Ausführungsform kann die Unterseite 5 des Deckelelements 7 vollständig beschichtet sein. Der Durchgangskontakt **4"** ist bei dieser Ausführungsform zentral angeordnet und kontaktiert eine der beiden Kontaktflächen 1a", 1b" des Kondensators 1" (hier beispielhaft die untere Kontaktfläche 1b"). Im Gegensatz zu den zuvor beschriebenen Ausführungsformen kontaktiert der Durchgangskontakt 4" hier das Stützelement 2 direkt und nicht über eine Teilbeschichtung der Unterseite des Deckelelements 7. Das Stützelement 2 ist bei dieser Ausführungsform vorzugsweise massiv ausgebildet.

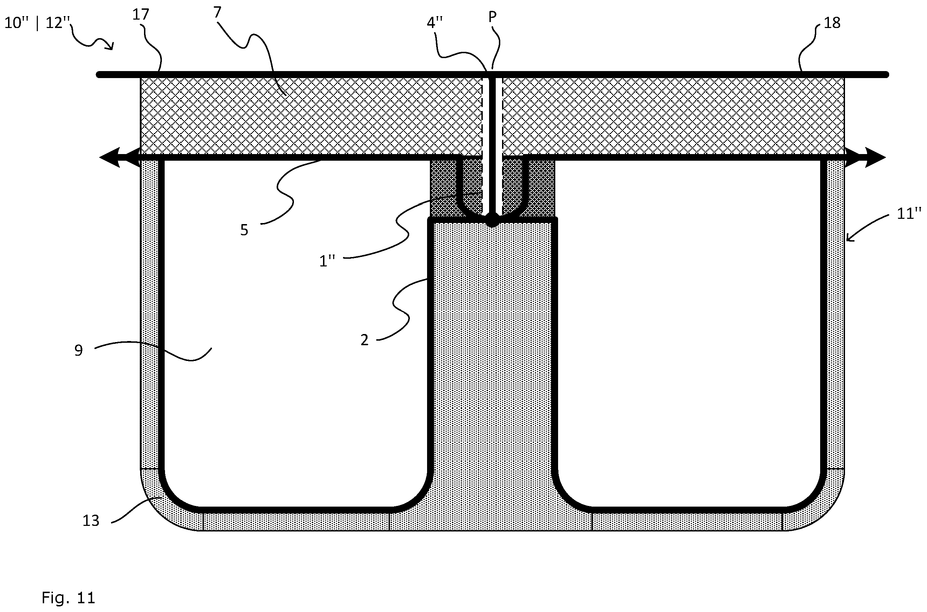

**Fig. 11** zeigt den entsprechenden Signalfluss beispielhaft für eine 1-Port Variante. Hochfrequente Anteile eines über die Eingangsleitung 17 eingekoppelten zu filternden HF-Signals werden vom Port P über den Durchgangskontakt 4", den Kondensator 1", das Stützelement 2 entlang der Innenwand des Hohlraums 9 der Außenwandung 13 des Spulenkörpers 11" zur Unterseite des Deckelelements 7 auf ein Referenzpotential (z.B. Erdpotential) geleitet. Niederfrequente Anteile eines über die Eingangsleitung 17 eingekoppelten zu filternden HF-Signals werden vom Port P über den Durchgangskontakt 4" und die Beschichtung 5 auf der Unterseite des Deckelelements 7 auf ein Referenzpotential (z.B. Erdpotential) geleitet. Der hierdurch nicht herausgefilterte Anteil des zu filternden HF-Signals wird über den Port P aus dem HF-Bandpassfilter 12"ausgekoppelt.

Die Resonatoren 10, 10', 10" können jeweils einzeln als erfindungsgemäßer HF-Bandpassfilter 12, 12', 12" fungieren (einfache Resonatoranordnung) oder mit anderen Resonatoren 10, 10', 10" zu einer komplexeren Resonatoranordnung 20 gekoppelt werden, um die Filterwirkung zu verbessern.

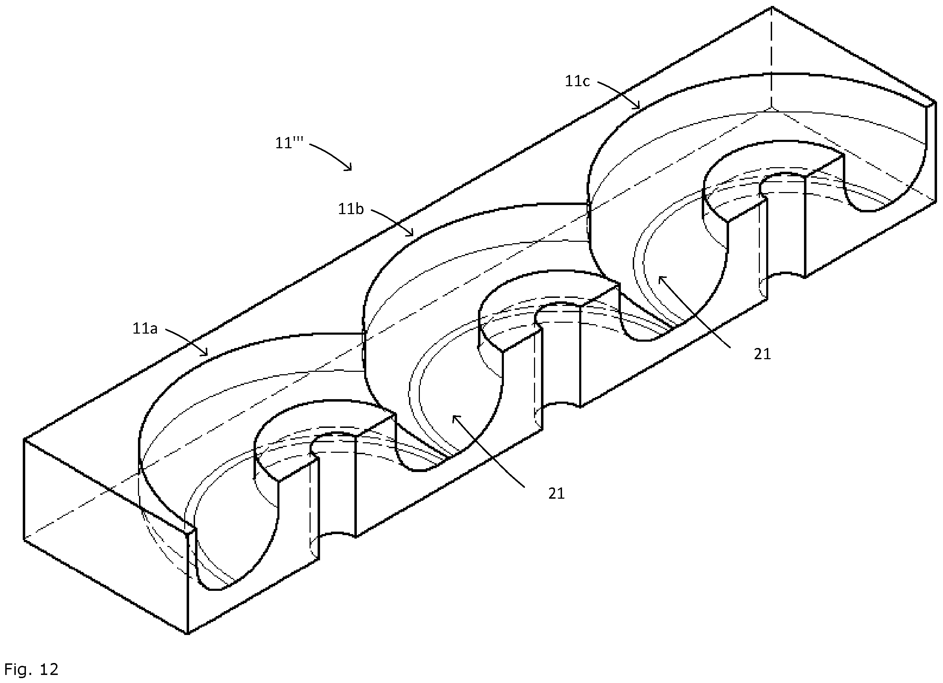

**Fig. 12** zeigt eine perspektivische Schnittdarstellung eines Spulenkörpers 11"' einer besonders bevorzugten Ausführungsform des erfindungsgemäßen HF-Bandpassfilters 12'" mit einer solchen Resonatoranordnung 20 mit gekoppelten Resonatoren 10. Der Spulenkörper 11'" umfasst mehre Teilspulenkörper 11a, 11b, 11c, die über Öffnungen **21** elektrisch und mechanisch miteinander verbunden sind, so dass die Magnetfelder miteinander koppeln können, wodurch eine besonders gute Performance erreicht wird. Der Spulenkörper 11'"', der die drei Teilspulenkörper 11a, 11b, 11c umfasst, ist vorzugsweise aus einem Stück hergestellt, (z.B. als ein einziges Frästeil) und wird vorzugsweise mit einem einzigen Deckelelement (nicht gezeigt) verschlossen, welches drei Teildeckelelemente umfasst, die die Komponenten der Deckelelemente von Einzelresonatoren aufweisen, wie zuvor beschrieben.

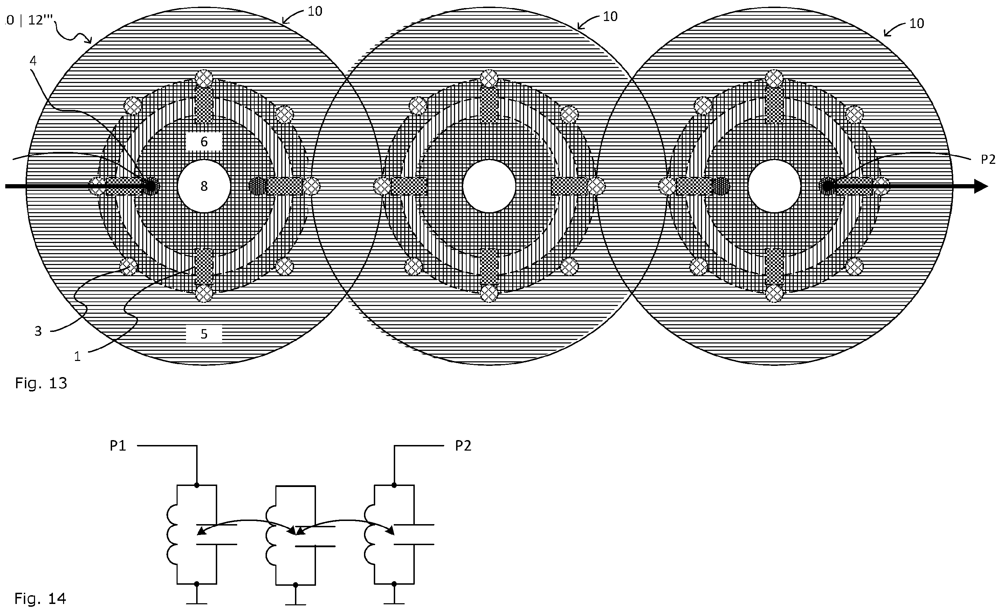

**Fig. 13** zeigt die Projektion der Komponenten der Resonatoranordnung 20 mit gekoppelten Resonatoren 10. Die äußeren beiden Resonatoren werden jeweils als 1-Port kontaktiert. Die gesamte Resonatoranordnung 20 ist somit dann wieder als 2-Port beschaltet. Ein Ersatzschaltbild der Resonatoranordnung 20 ist in **Fig. 14** dargestellt.

### Bezugszeichenliste

- 1: Kondensator innerhalb Hohlraum
- 1': Kondensator außerhalb Hohlraum
- 1": Kondensator in Stützelement
- 1a, 1a', 1a": erste Kontaktfläche des Kondensators
- 1b, 1b', 1b": zweite Kontaktfläche des Kondensators
- 2: elektrisch leitendes Stützelement
- 3: Sacklochkontakt
- 4: Durchgangskontakt
- 4": zentraler Durchgangskontakt
- 5: elektrisch leitende Schicht (Beschichtung)
- 5a: erste Teilbeschichtung
- 5b: zweite Teilbeschichtung
- 6: elektrisch leitende Zwischenschicht
- 7: Deckelelement (PCB)
- 8: Durchgangsöffnung
- 9: Hohlraum
- 10: Resonator mit Kapazität im Hohlraum (einfache Resonatoranordnung)
- 10': Resonator mit Kapazität im und außerhalb vom Hohlraum (einfache Resonatoranordnung)
- 10": Resonator mit Kapazität im Stützelement (einfache Resonatoranordnung)
- 11, 11' 11", 11‴: Spulenkörper
- 11a, 11b, 11c: Teilspulenkörper
- 12, 12', 12", 12'": HF-Bandpassfilter
- 13: Außenwandung
- 14: Resonatorachse
- 15: unbeschichtete Fläche
- 17: elektrische Eingangsleitung
- 18: elektrische Ausgangsleitung
- 20: Resonatoranordnung mit mehreren gekoppelten Resonatoren
- 21: Öffnung im Spulenkörper
- P: Port mit Signaleingang und Signalausgang
- P1: Port mit Signaleingang
- P2: Port mit Signalausgang

### Referenzliste

[1] "Helical resonator bandpass filter" https://coil32.net/design/helix-resonator.html
[2] Garbacz et al.
   "A loop-gap resonator for chirality-sensitive nuclear magneto-electric resonance (NMER)"
   The Journal of Chemical Physics 145, 104201 (2016)
   DOI: 10.1063/1.4962285
   https://aip.scitation.org/doi/abs/10.1063/1.496 2285
[3] Bobowski et al.
   "Permittivity and Conductivity Measured using a Novel Toroidal Split-Ring Resonator"
   https://arxiv.org/pdf/1901.00994.pdf
[4] Crypto Museum
   "Pulsed Cavity Resonant cavity microphone"
   https://www.cryptomuseum.com/covert/bugs/ec/cavity/index.htm
[5] Su et al
   "Slot Antenna Integrated Re-Entrant Resonator Based Wireless Pressure Sensor for High-Temperature Applications"
   Sensors 2017, 17, 1963;
   DOI: 10.3390/s17091963
   https://www.mdpi.com/1424-8220/17/9/1963/htm
[6] Anand et al.
   "Air Cavities Integrated with Surface Mount Tuning Components for Tunable Evanescent-Mode Resonators"
   https://www.researchgate.net/publication/306117073
   DOI: 10.1109/MWSYM.2016.7539960
[7] JP2001127502A
[8] MEHDIZADEH M ET AL:
   "Loop-Gap Resonator: A Lumped Mode Microwave Resonant Structure", IEEE TRANSACTIONS ON MICROWAVE THEORY AND TECHNIQUES, IEEE, USA
   Bd. 30, Nr. 12, 1. Dezember 1983 (1983-12-01), Seiten 1059-1064,
[9] HARDY W ET AL: "Split-ring resonator for use in magnetic resonance from 200-2000 MHz",
   REVIEW OF SCIENTIFIC INSTRUMENTS,
   Bd. 52, Nr. 2, 1. Februar 1981 (1981-02-01), Seiten 213-216,

## Patentansprüche

1. MR-Apparatur mit einer Sende- und/oder Empfangsanordnung mit einem Hochfrequenz-Bandpassfilter (12, 12', 12", 12"') umfassend eine Resonatoranordnung (10, 10', 10", 20) mit einem Signaleingang, einem Signalausgang und mindestens einem Resonator (10, 10', 10"), wobei jeder Resonator (10, 10', 10") eine Kapazität, die zu einer Induktivität parallelgeschaltet ist, aufweist,
**dadurch gekennzeichnet, dass**
die Induktivität einen elektrisch leitenden Spulenkörper (11, 11', 11", 11"") mit einem Hohlraum (9) umfasst, der im Wesentlichen HF-dicht verschlossen ist.
wobei der Resonator (10, 10', 10") ein Deckelelement (7) aufweist, das zusammen mit dem Spulenkörper (11, 11', 11", 11"") den Hohlraum (9) begrenzt,
wobei die Kapazität innerhalb des Hohlraums (9) angeordnet ist,
wobei zwischen der vom Hohlraum (9) abgewandten Seite und der dem Hohlraum (9) zugewandten Seite des Deckelelements (7) eine elektrisch leitende Zwischenschicht (6) angeordnet ist.

2. MR-Apparatur nach Anspruch 1, **dadurch gekennzeichnet, dass** der Hohlraum (9) des Spulenkörpers (11, 11"") rotationssymmetrisch, insbesondere abschnittsweise zylinderförmig, ausgeformt ist.

3. MR-Apparatur nach einem der vorhergehenden Ansprüche, **dadurch gekennzeichnet, dass** das Deckelelement (7) elektrisch isolierend und auf der dem Hohlraum (9) zugewandten Seite zumindest teilweise mit einem el. leitendem Material versehen, insbesondere beschichtet, ist.

4. MR-Apparatur nach einem der vorhergehenden Ansprüche, **dadurch gekennzeichnet, dass** das Deckelelement (7) mindestens einen Durchgangskontakt (4) aufweist, der eine der Kontaktflächen (1a, 1b) der Kapazität und den Spulenkörper (11, 11', 11", 11"") mit dem Signaleingang bzw. Signalausgang verbindet.

5. MR-Apparatur nach einem der vorhergehenden Ansprüche, **dadurch gekennzeichnet, dass** es sich bei dem Deckelelement (7) um eine Leiterplatte handelt.

6. MR-Apparatur nach einem der vorhergehenden Ansprüche, **dadurch gekennzeichnet, dass** die Kapazität mehrere parallel geschaltete Kondensatoren umfasst.

7. MR-Apparatur nach einem der Ansprüche 1 bis 5, **dadurch gekennzeichnet, dass** die Kapazität von einer mit el. leitendem Material beschichteten Isolatorscheibe (1"), insbesondere einer Keramikscheibe, gebildet wird.

8. MR-Apparatur nach einem der vorhergehenden Ansprüche, **dadurch gekennzeichnet, dass** die Resonatoranordnung mindestens zwei Resonatoren (10) umfasst, die miteinander gekoppelt sind.

9. MR-Apparatur nach Anspruch 8, **dadurch gekennzeichnet, dass** die Resonatoren (10) über ihre magnetischen Felder gekoppelt sind, wobei die Hohlräume (9) von jeweils zwei der mindestens zwei Resonatoren (10) über Öffnungen (21) in den Spulenkörpern (2) miteinander verbunden sind.

10. MR-Apparatur nach einem der vorhergehenden Ansprüche, **dadurch gekennzeichnet, dass** die Mittenfrequenz des HF-Bandpassfilters im zwei- bis dreistelligen MHz-Bereich liegt.

## Claims

1. MR apparatus comprising a transmission and/or receiving arrangement with a radio-frequency bandpass filter (12, 12', 12", 12'") comprising a resonator arrangement (10, 10', 10", 20) with a signal input, a signal output, and at least one resonator (10, 10', 10"), wherein each resonator (10, 10', 10") has a capacitor which is connected in parallel to an inductor,
**characterized in that**
the inductor comprises an electrically conductive coil body (11, 11', 11", 11"") having a cavity (9) which is closed in a substantially RF-tight manner, wherein the resonator (10, 10', 10") has a cover element (7) which, together with the coil body (11, 11', 11", 11""), delimits the cavity (9), wherein the capacitor is arranged within the cavity (9), wherein an electrically conducting intermediate layer (6) is arranged between the side facing away from the cavity (9), and the side of the cover element (7) facing the cavity (9).

2. MR apparatus according to claim 1, **characterized in that** the cavity (9) of the coil body (11, 11"") is rotationally symmetrical, in particular partially cylindrical.

3. MR apparatus according to any of the preceding claims, **characterized in that** the cover element (7) is electrically insulating and is at least partially provided, in particular coated, with an electrically conductive material on the side facing the cavity (9).

4. MR apparatus according to any of the preceding claims, **characterized in that** the cover element (7) has at least one via (4) which connects one of the contact surfaces (1a, 1b) of the capacitor and the coil body (11, 11', 11", 11"") to the signal input or signal output.

5. MR apparatus according to any of the preceding claims, **characterized in that** the cover element (7) is a printed circuit board.

6. MR apparatus according to any of the preceding claims, **characterized in that** the capacitor comprises a plurality of parallel-connected capacitors.

7. MR apparatus according to any of claims 1 to 5, **characterized in that** the capacitor is formed by an insulating disc (1") coated with electrically conductive material, in particular a ceramic disc.

8. MR apparatus according to any of the preceding claims, **characterized in that** the resonator arrangement comprises at least two resonators (10) which are coupled to one another.

9. MR apparatus according to claim 8, **characterized in that** the resonators (10) are coupled via their magnetic fields, wherein the cavities (9) of two of the at least two resonators (10) are connected to one another via openings (21) in the coil bodies (2).

10. MR apparatus according to any of the preceding claims, **characterized in that** the center frequency of the RF bandpass filter is in the two- to three-digit MHz range.

## Revendications

1. Appareil d'IRM avec un dispositif d'émission et/ou de réception avec un filtre passe-bande haute fréquence (12, 12', 12", 12"') comprenant un agencement de résonateur (10, 10', 10", 20) avec une entrée de signal, une sortie de signal et au moins un résonateur (10, 10', 10"), chaque résonateur (10, 10', 10") présentant une capacité, qui est connectée en parallèle à une inductance,
**caractérisé en ce que**
l'inductance comprend un corps de bobine électriquement conducteur (11, 11', 11", 11"") avec une cavité (9), qui est essentiellement étanche aux hautes fréquences,
le résonateur (10, 10', 10") présentant un élément de couvercle (7), qui, ensemble avec le corps de bobine (11, 11', 11", 11""'), délimite la cavité (9),
la capacité étant disposée à l'intérieur de la cavité (9),
et
entre le côté de l'élément de couvercle (7) tourné à l'opposé de la cavité (9) et le côté tourné vers la cavité (9), une couche intermédiaire électriquement conductrice (6) est disposée.

2. Appareil d'IRM selon la revendication 1, **caractérisé en ce que** la cavité (9) du corps de bobine (11, 11"") est à symétrie de rotation, en particulier formée par sections de forme cylindrique.

3. Appareil d'IRM selon l'une des revendications précédentes, **caractérisé en ce que** l'élément de couvercle (7) est électriquement isolant et, sur le côté tourné vers la cavité (9), est au moins partiellement pourvu d'un matériau électriquement conducteur, en particulier revêtu.

4. Appareil d'IRM selon l'une des revendications précédentes, **caractérisé en ce que** l'élément de couvercle (7) présente au moins un contact traversant (4), qui relie une des surfaces de contact (1a, 1b) de la capacité et le corps de bobine (11, 11', 11", 11"") à l'entrée de signal ou à la sortie de signal.

5. Appareil d'IRM selon l'une des revendications précédentes, **caractérisé en ce que** l'élément de couvercle (7) est une carte conductrice.

6. Appareil d'IRM selon l'une des revendications précédentes, **caractérisé en ce que** la capacité comprend plusieurs condensateurs connectés en parallèle.

7. Appareil d'IRM selon l'une des revendications 1 à 5, **caractérisé en ce que** la capacité est formée par un disque isolant (1"), en particulier un disque en céramique, revêtu d'un matériau électriquement conducteur.

8. Appareil d'IRM selon l'une des revendications précédentes, **caractérisé en ce que** l'agencement de résonateur comprend au moins deux résonateurs (10) qui sont couplés entre eux.

9. Appareil d'IRM selon la revendication 8, **caractérisé en ce que** les résonateurs (10) sont couplés par leurs champs magnétiques, les cavités (9) de deux des au moins deux résonateurs (10) étant reliées entre elles par des ouvertures (21) dans les corps de bobine (2).

10. Appareil d'IRM selon l'une des revendications précédentes, **caractérisé en ce que** la fréquence centrale du filtre passe-bande haute fréquence se situe dans la plage de MHz à deux ou trois chiffres.
